(19) Europäisches Patentamt
European Patent Office
Office européen des brevets

(11) **EP 3 110 614 B1**

## (12) EUROPEAN PATENT SPECIFICATION

(45) Date of publication and mention
of the grant of the patent:
**19.02.2020 Bulletin 2020/08**

(21) Application number: **15711858.9**

(22) Date of filing: **19.02.2015**

(51) Int Cl.:
*G02B 26/08* (2006.01)       *G02B 26/10* (2006.01)
*B33Y 30/00* (2015.01)       *B29C 64/135* (2017.01)
*B29C 64/268* (2017.01)

(86) International application number:
**PCT/IB2015/051283**

(87) International publication number:
**WO 2015/128783 (03.09.2015 Gazette 2015/35)**

(54) **IMPROVED STEREOLITHOGRAPHY MACHINE**

VERBESSERTE STEREOLITHOGRAFISCHE MASCHINE

MACHINE DE STÉRÉOLITHOGRAPHIE AMÉLIORÉE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **28.02.2014 IT VI20140048**

(43) Date of publication of application:
**04.01.2017 Bulletin 2017/01**

(73) Proprietor: **DWS S.R.L.**
**36016 Thiene (VI) (IT)**

(72) Inventor: **COSTABEBER, Ettore Maurizio**
**36010 Zane (IT)**

(74) Representative: **Marchioro, Paolo et al**
**Studio Bonini S.r.l.**
**Corso Fogazzaro, 8**
**36100 Vicenza (IT)**

(56) References cited:
**JP-A- H05 309 747       US-A- 5 151 813
US-A- 5 389 196       US-B1- 6 426 840**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

The present invention concerns a stereolithography machine suited to produce a three-dimensional object through the superimposition of a plurality of layers of a base material, in the liquid or paste state, that is solidified through selective exposure to a light beam.

A stereolithography machine of the known type comprises a container suited to contain the base material.

Said machine furthermore comprises a light emitting unit configured so as to emit a light beam that is substantially circular in shape and collimated, meaning with substantially parallel rays.

Each layer of the three-dimensional object is solidified at the level of a predefined plane incidence area belonging to the outer surface of the base material, on which the light beam is incident.

The incidence area may belong to the bottom of the container that contains the base material or to the free surface of the base material itself, depending on whether the light beam arrives from below or from above with respect to the container.

Said machine comprises also light reflecting means that deviate the light beam selectively towards any point of the incidence area.

Generally, the light reflecting means are two galvanometric mirrors, which are movable in rotation according to respective mutually perpendicular axes, in such a way that it is possible to deviate the light beam according to respective mutually orthogonal planes.

Said machine comprises also a so-called "F-theta" lens, interposed between the light reflecting means and the incidence area.

Said F-theta lens makes the collimated light beam converge in such a way as to focus it on the plane incidence area, independently of the direction of the incident light beam.

The machine described above poses the drawback that it is particularly expensive and that, therefore, its use is mainly confined to the professional and industrial field, which makes it unsuitable for a wider range of applications. The main cause of said drawback is the presence of the F-theta lens, which substantially affects the overall cost of the machine.

A further drawback of the F-theta lens derives from the fact that its size is related to the size of the incidence area and, therefore, to the maximum size of the three-dimensional object that can be obtained.

As the cost of said lenses increases more than proportionally to the size of the incidence area that they make it possible to obtain, an increase in the size of the incidence area involves the drawback of considerably increasing the cost of the F-theta lens and thus the cost of the machine.

Furthermore, due to the high cost of the F-theta lenses, they are available on the market only in a limited number of standard versions, each one of which is designed to obtain a square incidence area having a specific size.

Consequently, the manufacturer of the stereolithography machine must select the size of the incidence area among a limited number of predefined sizes, with the drawback that it is not possible to produce optimized stereolithography machines for all the possible applications.

Furthermore, for optical reasons, the minimum cross section of the light beam that is focused by said F-theta lenses increases to a degree that is substantially proportional to the focal length of the same and, therefore, to the size of the incidence area, thus worsening the definition of the image that can be traced on the incidence area and therefore worsening the definition of the object.

Consequently, there is the drawback that an increase in the size of the incidence area can be obtained only against a considerably increase in the cost of the machine and a reduced definition of the object.

Due to said drawbacks, the manufacturers of stereolithography machines prefer to use F-theta lenses with a short focal length, accepting an incidence area in a correspondingly reduced size, as this makes it possible to limit the cost of the machine in relation to the level of definition that can be obtained.

Consequently, there is the drawback that these machines pose a limit to the size of the objects that can be obtained.

According to a different prior art technique disclosed in document US 5,151,813, on which the preamble of claim 1 is based, the machine comprises a dynamic lens arranged upstream of the reflecting device. The lens is moved in the focusing direction while the beam is scanned across the incidence area, so as to maintain the beam always focused on the incidence area for any incidence direction defined by the reflecting device.

It is the object of the present invention to overcome all the above mentioned drawbacks that are typical of the stereolithography machines of known type.

In particular, it is a first object of the present invention to provide a stereolithography machine suited to be used in a wider range of sectors and not only in the strictly professional and industrial sectors.

In particular, it is the object of the present invention to provide a stereolithography machine that, with the same size of the incidence area and the same definition of the light beam, costs considerably less than a machine of known type.

It is also the object of the invention to offer the manufacturer more flexibility in the choice of the size of the incidence area compared to that which happens with the machines of known type.

The above mentioned objects are achieved by a stereolithography machine constructed according to claim 1.

Further characteristics and details of the invention are described in the corresponding dependent claims.

Advantageously, the increased exploitability of the machine of the invention makes it possible to increase the flexibility and diffusion of stereolithography modelling compared to the machines of known type.

Still advantageously, the reduced cost of the machine of the invention makes it particularly advantageous to increase the size of the incidence area, so that it is possible to obtain three-dimensional objects that are larger than those obtainable with the stereolithography machines of the known type.

Furthermore, advantageously, the higher flexibility in the choice of the size of the incidence area makes it possible to optimize the machine based on its intended use.

The said objects and advantages, together with others which will be highlighted below, are illustrated in the description of a preferred embodiment of the invention which is provided by way of non-limiting example with reference to the attached drawings, wherein:

- Figure 1 schematically shows an axonometric view of the stereolithography machine that is the subject of the invention;
- Figure 2 shows a side sectional view of the stereolithography machine shown in Figure 1 in an operating configuration;
- Figures 3 and 4 show side sectional views of enlarged details of the machine shown in Figure 1 in two respective operating configurations;
- Figure 5 schematically shows the operating areas of the machine shown in Figure 1.

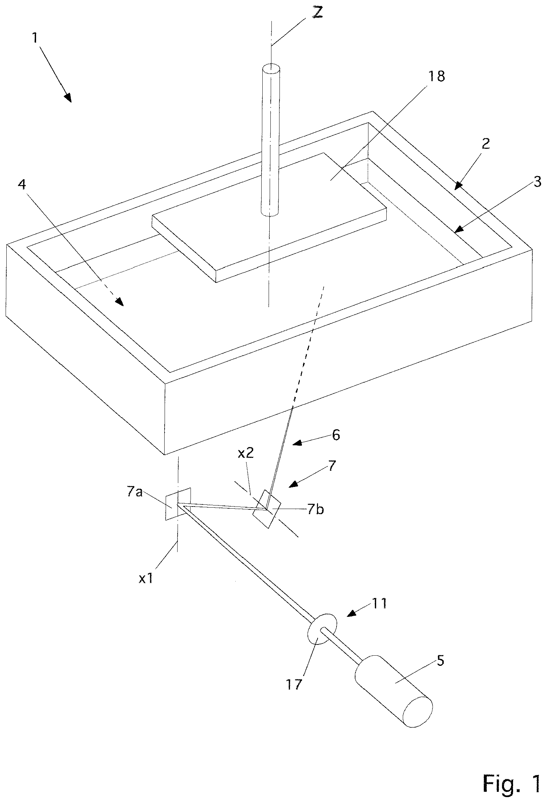

The stereolithography machine of the invention, indicated as a whole by the reference number **1** in Figure 1, is suitable for producing a three-dimensional object through the superimposition of a plurality of layers obtained from the solidification of a base material **3**, in the liquid or paste state, arranged in a container **2**.

Said layers are supported by a modelling plate **18**, driven according to a vertical axis **Z** and suited to arrange any solidified layer of the three-dimensional object in such a position that it serves as a support for the successive layer.

A light emitting unit **5** configured so as to emit a light beam **6** is also provided. Preferably, said light emitting unit **5** comprises a laser source and a collimator of the light beam **6.**

Preferably, said light emitting unit **5** comprises also a device suited to obtain for the collimated beam a cross section having a symmetric shape according to two mutually orthogonal axes of symmetry and preferably circular or substantially circular.

It should be pointed out since now that when, here below, reference is made to the diameter of a generic cross section of the light beam, this will mean the diameter of the circumference whose surface area is equal to the surface area of said generic cross section.

The stereolithography machine **1** furthermore comprises a light reflecting device **7** suited to deviate the light beam **6** and to be controlled in such a way as to make the light beam **6** be incident on any point of an incidence area **8** belonging to an external surface **4** of the base material **3**.

Preferably, the requisite just described above is met using a light reflecting device **7** comprising two mirrors **7a, 7b** that revolve independently of each other with predefined angular amplitudes around respective mutually perpendicular rotation axes **X1, X2.**

Preferably, each mirror **7a, 7b** is made rotate around the respective rotation axis through a corresponding galvanometric motor.

According to a variant embodiment of the invention not illustrated herein, the light reflecting device **7** comprises only one mirror that revolves around two mutually independent and orthogonal axes.

In this case, said mirror is preferably of the so-called MOEMS type, the acronym for "Micro-opto-electro-mechanical system".

In the embodiment illustrated in the figures, said incidence area **8** is adjacent to the bottom of the container **2.**

This configuration is obtained with the light beam **6** incident on the container **2** from the bottom, said container having a transparent bottom in such a way as to allow the light beam **6** to reach the base material **3.**

According to a variant embodiment of the invention, not illustrated in the drawings, the light beam **6** is incident on the top of the container **2** itself and the incidence area **8** thus belongs to the free surface of the base material **3**. In this case, the machine preferably comprises a levelling device suited to give a plane shape to said free surface.

In any case, the area of intersection of the light beam **6** with the incidence area **8,** defined "spot" in technical jargon, determines the size of the area of the base material **3** that is solidified and thus determines the definition of the three-dimensional object.

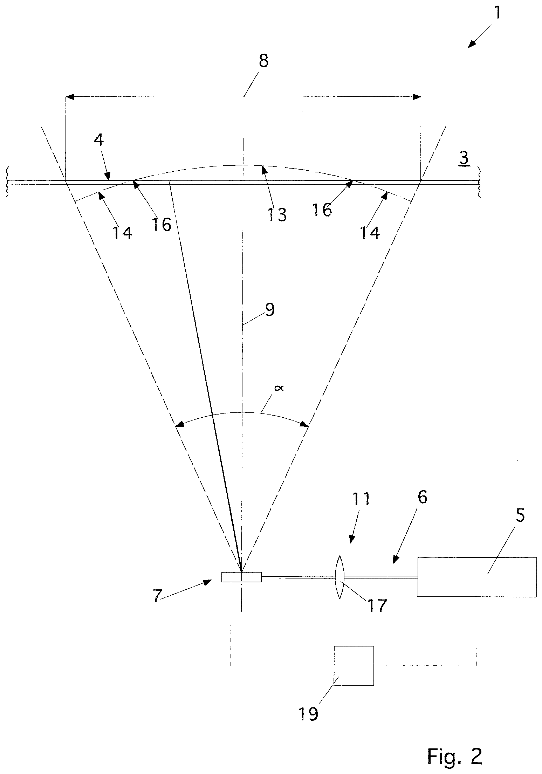

The machine **1** comprises also a logic control unit **19,** schematically represented in Figure 2, configured to control the light reflecting device **7** in such a way that the light beam **6** is selectively incident on any point of the operating area **10** belonging to the incidence area **8.**

It should be highlighted that, while the incidence area **8** is determined by the operating limits of the light reflecting device **7,** the operating area **10** is determined by the logic control unit **19** and, therefore, can be limited to a part of the incidence area **8.**

The stereolithography machine **1** is also provided with an optical unit **11,** configured so as to focus the light beam **6** on a focal surface **12** defined by the points where the light beam **6,** along the different directions defined by the light reflecting device **7,** has minimum cross section.

It is evident that said focal surface **12** is defined by the combined action of the optical unit **11,** which defines the focusing distance of the light beam **6** from the light reflecting device **7,** and of the light reflecting device **7** itself, which defines the focusing direction.

Obviously, downstream of said focal surface **12** along the direction of propagation of the light beam **6,** the surface area of the cross section of the light beam **6** increases with respect to the surface area of the minimum cross section.

For a laser light beam, it is known that the distribution of energy in each cross section of said beam is of the Gaussian type.

Here below, a "Gaussian light beam" means a light beam having the property just described above.

As is known, the generic cross section of a Gaussian light beam is conventionally defined as the wavefront area in which the intensity of the energy is higher than or equal to $1/e^2$ times the maximum intensity present at the centre of the beam itself, where **e** is Nepero's number.

According to an alternative definition, the cross section of the Gaussian beam is the area of the wavefront in which the intensity of the energy is higher than or equal to half the maximum intensity.

It should be specified since now that the present description is independent of the definition provided for the cross section of the beam and, in particular, is not limited to a specific one of the two definitions mentioned above.

As is also known, the minimum cross section of a convergent Gaussian beam, which is defined as "waist" in technical jargon, has a surface area that is larger than zero.

Therefore, with reference to a Gaussian beam, the term "focus" does not indicate a single point, but said minimum cross section.

In particular, the surface area of the minimum cross section **15** of the light beam **6** obtained by focusing a Gaussian beam depends on various parameters, among which, in particular, the focal length of the optical unit **11** and the cross section of the collimated laser beam, according to the known formula:

$$(1) \qquad w_F = \frac{\lambda \cdot f \cdot M^2}{\pi \cdot w_L}$$

wherein $w_F$ is the diameter of the minimum cross section of the beam ("waist"), $\lambda$ is the wavelength, **f** is the focal length of the optical unit **11**, $M^2$ is the quality coefficient of the beam, which expresses the actual distribution of energy compared to the ideal case of Gaussian distribution, and $w_L$ is the diameter of the cross section of the collimated beam that is incident on the optical unit **11.**

It is also known that the diameter **w** of a Gaussian beam as a function of the generic distance **z** from the cross section with minimum diameter $w_F$ can be expressed with the following formula:

$$(2) \qquad w(z) = w_F \cdot \left[ 1 + \left( \frac{z \cdot \lambda \cdot M^2}{\pi \cdot w_F^2} \right)^2 \right]^{1/2}$$

Said formula (2) highlights how a Gaussian beam converges towards and diverges from the cross section with minimum diameter $w_F$ in a way that is substantially proportional to the distance **z,** except for a neighbourhood of the minimum cross section, in which the geometric shape of the beam is rounded, similar to the neck of an hourglass.

According to the invention, the optical unit **11** that produces the focusing of the light beam **6** is interposed between the light emitting unit **5** and the light reflecting device **7.**

As the optical unit **11** is arranged upstream of the light reflecting device **7** according to the direction of propagation of the light beam **6,** the latter is always incident on the same point of the optical unit **11,** independently of the point of incidence of the beam on the operating area **10.**

Therefore, it is possible to use an optical unit **11** based on a common lens or set of lenses **17** arranged in series, for example of the spherical, biconvex or plano-convex type, in any case much more economical than a F-theta lens.

Analogously to a F-theta lens, also said optical unit **11** is of the fixed type, which therefore does not require any device for moving the optical unit **11** in order to adjust the focus, to the advantage of the simple construction structure of the machine.

On the other hand, said fixed configuration of the optical unit **11** does not allow the light beam **6** to be focused on the operating area **10.**

In fact, the optical unit **11** focuses the light beam **6** at a constant distance from the light reflecting device **7,** independently of the direction of incidence of the light beam **6** determined by the light reflecting device **7** itself. Therefore, the focal surface **12** has a spherical rather than a plane shape, centered at the level of the light reflecting device **7,** as can be observed in Figure 2, which schematically represents a sectional view of the machine **1** according to a section plane passing through the centre of the operating area **10.**

It is underlined since now that in Figure 2 the light reflecting device is represented schematically for the sake of clarity.

Obviously, said spherical focal surface **12** cannot coincide with the operating area **10** that is plane. Therefore, in the machine **1** of the invention, the surface area of the spot varies depending on the point of incidence on the operating area **10,** with the consequence that the surface area of the portion of the base material **3** that solidifies varies from a point to another.

In particular, the size of the spot increases as the distance between the focal surface **12** and the operating area **10** measured along the direction of the light beam **6** increases, in accordance with the formula (2).

In general, the situation described above does not allow a sufficiently homogeneous and defined solidification of the three-dimensional object to be obtained.

However, the applicant who files the present invention has found out that, by properly configuring the light beam **6,** the focal surface **12** and the operating area **10,** it is possible to limit said drawback to an acceptable level, at least in not strictly professional or industrial sectors.

Therefore, the invention also includes the definition of the light beam **6,** of the focal surface **12** and of the operating area **10** through a suitable selection of the light emitting unit **5** and of the optical unit **11,** such that the ratio between the maximum diameter of the spot and the diameter $w_F$ of the minimum cross section **15** does not exceed 1.15.

In this way, the maximum variation in the diameter of the spot in the entire operating area **10** is limited to 15%.

The applicant who files the present invention has observed that said variation in the spot size practically makes any difference in the solidification of the base material **3** on the operating area **10** negligible, thus making it possible to obtain a machine **1** whose performance is compatible with use in sectors that are not strictly professional or industrial.

According to the above, it can be understood that the invention achieves the object to provide a stereolithography machine **1** that, in terms of both cost and performance, is particularly suitable for use in sectors that are not strictly professional or industrial.

Preferably, said ratio between diameters is included between 1.10 and 1.15, to further advantage in terms of performance of the machine **1.** The applicant who is filing the present invention has observed that the variation in the ratio within said interval can be obtained through optical units **11** that cost considerably less than a F-theta optical unit.

The arrangement of the optical unit **11** upstream of the light reflecting device **7** makes it possible to achieve also the object to obtain more flexibility in the selection of the size of the operating area **10** compared to the machines of known type.

In fact, in the machine **1** of the invention, the size of the operating area **10** for a light reflecting device **7** having a given angular movement amplitude $\alpha$ substantially depend on the distance of the light reflecting device **7** from the incidence area **8,** which may be easily modified, and on the availability of a lens with suitable focal length.

On the contrary, in the machines of known type using a F-theta lens, the size of the operating area **10** are determined by the lens, which is available on the market in a limited number of versions, as already explained above.

The light emitting unit **5** and the optical unit **11** are selected by determining at least the diameter $w_L$ and the quality $M^2$ of the collimated beam, as well as the focal length **f** of the optical unit **11,** which make it possible to minimize the minimum diameter $w_F$ of the beam, always on condition that the diameter of the spot is maintained within the values indicated above.

Minimizing the minimum diameter $w_F$, while the other conditions remains the same, means minimizing also the maximum diameter of the spot and, therefore, the definition obtainable with the machine **1.**

Supposing that the optical unit **11** does not present any aberration, said minimization of $w_F$ can be performed using the formulas (1) and (2), wherein in formula (2) **z** must be equal to the value of the maximum distance $z_{max}$ between the focal surface **12** and the operating area **10** and the ratio $w(z_{max})/w_F$ must be equal to the maximum ratio mentioned above.

Actually, the optical unit **11** is never without aberrations. The aberration that is relevant in this context is, in particular, the spherical aberration, which will be shortly defined simply as "aberration" here below.

As is known, the aberration has the effect of enlarging the focusing area of the rays of a given beam.

In the case of a Gaussian beam subject to aberration, its geometry can be described by means of more complex formulas compared to said formulas (1) and (2), which are not illustrated herein for the sake of simplicity, being however known in the literature.

Here it is sufficient to note that for a Gaussian beam a higher aberration, the other conditions remaining the same, involves a larger minimum diameter $w_F$ as well as a longer length **L** of the portion of the beam that meets the condition on the variation in diameter mentioned above.

Therefore, if on one side the increase in the minimum diameter $w_F$ would suggest that the aberration be limited as much as possible, on the other side a higher aberration makes it possible to reduce the diameter $w_L$ downstream of the optical unit **11,** consequently reducing also the minimum diameter $w_F$. Which of the two effects will prevail depends on the specific configuration selected for the machine **1** and therefore cannot be known in advance.

Therefore, preferably, the aberration is used as a further unknown factor in the calculation for the minimization of the minimum diameter $w_F$, considered that, for a given focal length **f,** several lenses with aberration values different from one another are generally available on the market.

Advantageously, the use of the aberration as unknown factor of the calculation in many cases makes it possible to obtain a minimum diameter $w_F$ that is shorter than the diameter that would be obtained considering an optical unit **11** with a pre-determined aberration, for example with the minimum aberration available on the market for a given focal length.

The above mentioned advantage must be added to the fact that, generally, the cost of the optical unit **11** decreases as its aberration increases. Therefore, if said calculation provides a higher aberration than the minimum available on the market for a given local length, the corresponding optical unit **11** will cost less than the optical unit with minimum aberration, to the advantage of the overall cost of the machine **1.**

As regards the focal surface **12,** this is preferably defined in such a way as to intersect the incidence area **8,** in order to obtain a first portion **13** arranged inside the base material **3** and a second portion **14** arranged outside the base material **3.**

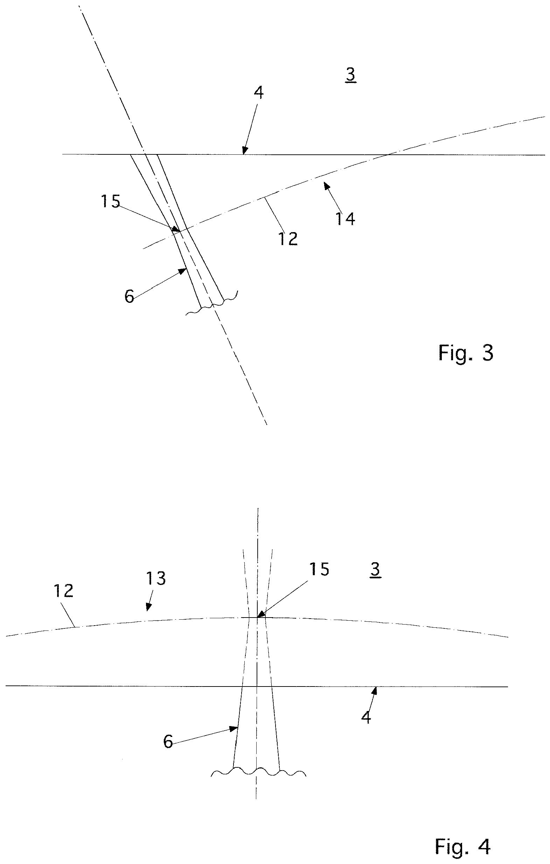

Therefore, when the light beam **6** is directed towards the first portion **13** of the focal surface **12,** it is incident on the operating area **10** before reaching the minimum cross section **15,** as schematically shown in Figure 4. A portion of the light beam **6** upstream of the minimum cross section **15** is thus exploited.

Vice versa, when the light beam **6** is directed towards the second portion **14** of the focal surface **12,** it reaches the operating area **10** after passing past the minimum cross section **15,** as shown in Figure 3. A portion of the light beam **6** downstream of the minimum cross section **15** is thus exploited.

Advantageously, the other conditions remaining the same, said configuration makes it possible to reduce the maximum distance $z_{max}$ between focal surface **12** and work surface **10,** allowing the minimum diameter $w_F$ to be reduced.

Preferably, the focal surface **12** is arranged in such a way that the maximum surface area of the spot obtained when the light beam **6** is directed towards the first portion **13** is equal to the maximum surface area of the spot obtained when the light beam **6** is directed towards the second portion **14.**

Advantageously, the configuration just described above makes it possible to minimize the minimum diameter $w_F$ for an operating area **10** of a predefined size.

Meeting the requisite just described above means arranging the focal surface **12** with respect to the operating area **10** in such a way that the sum of the maximum distance between the first portion **13** and the operating area **10** with the maximum distance between the second portion **14** and the operating area **10,** measured along the direction of propagation of the light beam **6,** is equal to the length **L** of the portion of the light beam **6** that meets the condition on the maximum diameter illustrated above.

In practice, due to the aberrations, said portion of the light beam **6** is not arranged symmetrically with respect to the minimum cross section **15,** as would happen if there were no aberrations, but it is moved upstream with respect to the minimum cross section **15.**

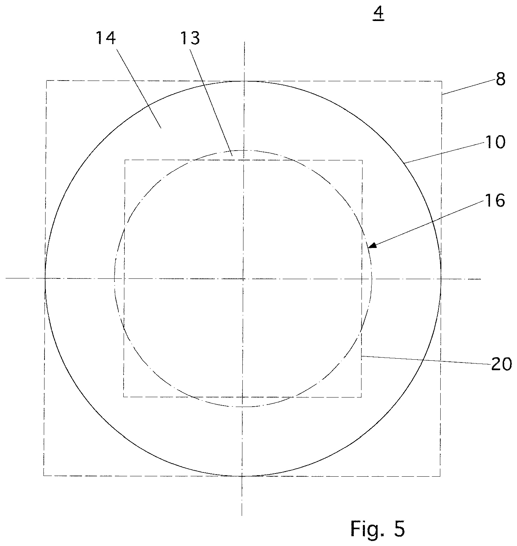

Preferably, the light reflecting device **7** is configured in such a way that the intersection between the focal surface **12** and the operating area **10** is a circumference **16** that is schematically represented in Figure 5 together with the incidence area **8** and the operating area **10.**

Said circumference **16** is obtained by arranging the outer surface **4** so that it is orthogonal to the bisecting lines **9** of the overall operating angles $\alpha$ of the light reflecting device **7** around each one of the two axes **X1, X2.**

Said condition makes it possible to obtain a spot that is variable in an axial symmetric way around said bisecting line **9,** i.e. having the same geometry for all directions of incidence that form the same angle with the bisecting line **9.**

Consequently, to advantage, it is possible to minimize the maximum size of the spot in the operating area **10** for a given surface area of the latter.

Still advantageously, said axial symmetry makes it possible to simplify the numeric representation of the three-dimensional object that is used to plan the path of the light beam **6** during the actual construction of the object itself.

Preferably, the logic control unit **19** is configured in such a way that the operating area **10** has a circular shape, concentric with said circumference **16.** The configuration just described above makes it possible to minimize the maximum distance $z_{max}$ between the operating area **10** and the focal surface **12** and, thus, makes it possible to reduce the maximum size of the spot with the same surface area of the operating area **10.**

Obviously, the result just mentioned above is obtained by arranging the focal surface **12** so that the spot has its maximum surface area simultaneously at the level of the centre and of the perimeter of the operating area **10.**

In the common case in which the light reflecting device **7** defines an incidence area **8** that is square in shape, defining a circular operating area **10** means excluding the parts of the incidence area **8** arranged at the level of the vertices, thus considerably reducing said maximum distance $z_{max}$.

Consequently, to advantage, it is possible to reduce the size of the spot compared to the size that would be obtained using an operating area coinciding with the entire square incidence area **8.**

Preferably, the circular operating area **10** is defined in such a way that it is inscribed in the incidence area **8,** as schematically shown in Figure 5, thus maximizing the surface area of the operating area **10** for a given incidence area **8** and exploiting the resolution of the light reflecting device **7** as much as possible.

By way of example, the most commonly used machines of known type are provided with a light reflecting device that operates on an angular amplitude of 40° and with a F-theta lens with focal length equal to 160 mm. This combination provides an operating area **20** measuring 110 x 110 mm and a circular spot whose diameter is equal to approximately 40 $\mu$m.

Using the inventive concept described above, the applicant who is filing the present invention could obtain a circular operating area **10** with diameter equal to 180 mm and a spot with diameter equal to approximately 60 $\mu$m.

Figure 5 qualitatively expresses that which has been described above. In particular, it can be observed that the operating area **10** is considerably larger than the operating area **20** of the known machine, though being smaller than the incidence area **8.**

Therefore, accepting a slight reduction in the definition, it has been possible to double the surface area of the operating area **10,** with no need to increase the cost of the machine, rather, reducing it compared to the machines of known type.

It can be understood that the reduced cost of the machine of the invention makes the latter particularly suited to be used in a wider range of sectors than those strictly professional or industrial for which the machines of known type are intended, precisely those sectors in which the main requisite to be met is the cost of the machine, while definition is considered of secondary importance.

On the other hand, with a machine of the known type, in order to obtain an operating area whose surface area can be compared to that with a diameter of 180 mm indicated above, it is necessary to use a F-theta lens with a focal length of approximately 250 mm, corresponding to a square operating area measuring approximately 160 x 160 mm.

However, said F-theta lens is much more expensive than the F-theta lens of the previous case and, furthermore, makes it possible to obtain a spot in a size that in any case can be compared to that obtainable with said machine of the invention.

In practice, the diameter of the operating area **10** is preferably included between 170 mm and 190 mm. Said interval is suitable for a wide range of applications and, furthermore, makes it possible to obtain a definition and an operating area that can be compared to those obtainable with said F-theta lens with a focal length equal to approximately 250 mm, but at a considerably lower cost.

The above clearly shows that the stereolithography machine described above achieves all the objects of the invention.

In particular, the specific configuration of the optical unit and of the light emitting unit makes it possible to drastically reduce the cost of the machine compared to the machines of known type, making the machine suitable for use in a wider range of sectors and not only in the professional or industrial sectors.

Furthermore, said configuration makes it also possible to make the size of the operating area independent of a specific optical unit, thus increasing flexibility in the design of the machine and allowing the operating area to be widened without excessively increasing the cost of the machine.

**Claims**

1. Stereolithography machine (1) comprising:

   - a container (2), containing a base material (3) in a liquid or paste state defining an external surface (4) delimiting said base material;
   - a light emitting unit (5) configured so as to emit a light beam (6);
   - a light reflecting device (7) suited to deviate said light beam (6) and to be controlled in such a way that said light beam (6) is incident on any point of an incidence area (8) belonging to said external surface (4);
   - a logic control unit (19) configured so as to control said light reflecting device (7) in such a way that said light beam (6) is selectively incident on any point of an operating area (10) belonging to said incidence area (8);
   - an optical unit (11) configured so as to focus said light beam (6) on a focal surface (12) defined by the points where said light beam (6) has minimum cross section (15) along the different directions defined by said light reflecting device (7), said optical unit (11) being arranged between said light emitting unit (5) and said light reflecting device (7);

**characterized in that** said optical unit (11) is configured in such a way that said focal surface (12) is spherical, **and in that** said light emitting unit (5) and said optical unit (11) are configured in such a way that the ratio between the maximum diameter of the intersection between said light beam (6) and said operating area (10) across the entire operating area (10), and the diameter ($w_F$) of said minimum cross section (15), does not exceed 1.15.

2.  Stereolithography machine (1) according to claim 1, **characterized in that** said optical unit (11) is fixed.

3.  Stereolithography machine (1) according to any one of the claims 1 or 2, **characterized in that** said light emitting unit (5) and said optical unit (11) are configured in such a way that said ratio is included between 1.10 and 1.15.

4.  Stereolithography machine (1) according to any of the preceding claims, **characterized in that** said light emitting unit (5) and said optical unit (11) are configured so as to minimize said diameter ($w_F$) of said minimum cross section (15), with a given predefined configuration of said operating area (10) and a given predefined distance between said operating area (10) and said light reflecting device (7).

5.  Stereolithography machine (1) according to any of the preceding claims, **characterized in that** said focal surface (12) is arranged so as to intersect said operating area (10) in such a way that a first portion (13) of said focal surface (12) is arranged within said base material (3) and **in that** a second portion (14) of said focal surface (12) is arranged outside said base material (3).

6.  Stereolithography machine (1) according to claim 5, **characterized in that** said light emitting unit (5) and said optical unit (11) are configured in such a way that the maximum intersection area between said light beam (6) and said operating area (10) when said light beam (6) is directed towards said first portion (13) is equal to the maximum intersection area between said light beam (6) and said operating area (10) when said light beam (6) is directed towards said second portion (14).

7.  Stereolithography machine (1) according to any of the claims 5 or 6, **characterized in that** said light reflecting device (7) is configured in such a way that the intersection between said focal surface (12) and said operating area (10) is a circumference (16).

8.  Stereolithography machine (1) according to claim 7, **characterized in that** said logic control unit (19) is configured in such a way that said operating area (10) is circular and concentric with said circumference (16).

9.  Stereolithography machine (1) according to claim 8, **characterized in that** said circular operating area (10) is inscribed in said incidence area (8).

10. Stereolithography machine according to claim 9, **characterized in that** the diameter of said circular operating area (10) is included between 170 mm and 190 mm.

11. Stereolithography machine (1) according to any of the preceding claims, **characterized in that** said optical unit (11) is a lens or set of lenses (17) arranged in series.

12. Stereolithography machine (1) according to any of the preceding claims, **characterized in that** said light emitting unit (5) is configured in such a way that it emits a collimated light beam (6).

13. Stereolithography machine (1) according to claim 12, **characterized in that** said light emitting unit (5) comprises a laser emitter.

14. Stereolithography machine (1) according to any of the claims 12 or 13, **characterized in that** said light emitting unit (5) is configured in such a way that the cross section of said collimated light beam (6) is symmetrical according to two mutually orthogonal axes of symmetry.

15. Method for designing a stereolithography machine (1) according to any of the preceding claims, **characterized in that** it comprises the following operations:

    - defining a configuration for said operating area (10);

- defining a distance between said light reflecting device (7) and said operating area (10);
- calculating the values of some design parameters for said light emitting unit (5) and said optical unit (11) in such a way as to minimize the value of said diameter ($w_F$) of said minimum cross section (15) under the condition that the value of the ratio between the maximum diameter of the intersection between said light beam (6) and said operating area (10) across the entire operating area (10), and the diameter ($w_F$) of said minimum cross section (15), is less than, or equal to, 1.15, said design parameters comprising at least the diameter ($w_L$) and the quality coefficient ($M^2$) of said light beam (6) incident on said optical unit (11), and the focal length (f) of said optical unit (11);
- selecting said light emitting unit (5) and said optical unit (11) according to said values of said design parameters.

16. Method according to claim 15, **characterized in that** said design parameters comprise a parameter representative of the aberration of said optical unit (11).

**Patentansprüche**

1. Stereolithographiemaschine (1), Folgendes umfassend:

   - einen ein Grundmaterial (3) in flüssigem oder pastösem Zustand enthaltenden Behälter (2), der eine Außenfläche (4) definiert, die das besagte Grundmaterial begrenzt;
   - eine Leuchteinheit (5), die dazu konfiguriert ist, einen Lichtstrahl (6) abzugeben;
   - eine lichtreflektierende Vorrichtung (7), dazu geeignet, den besagten Lichtstrahl (6) abzulenken und derart gesteuert zu werden, dass der besagte Lichtstrahl (6) auf einen jeglichen Punkt eines zu der besagten Außenfläche (4) gehörenden Einfallsbereichs (8) einfällt;
   - eine Steuerlogikeinheit (19), die so konfiguriert ist, die besagte lichtreflektierende Vorrichtung (7) so zu steuern, dass der besagte Lichtstrahl (6) wahlweise auf einen jeglichen Punkt eines zu dem besagten Einfallsbereichs (8) gehörenden Betriebsbereichs (10) einfällt;
   - eine optische Einheit (11), die so konfiguriert ist, dass der besagte Lichtstrahl (6) auf eine Brennfläche (12) fokussiert wird, welche durch die Punkte definiert ist, in denen der besagte Lichtstrahl (6) entlang der verschiedenen, durch die besagte lichtreflektierende Vorrichtung (7) definierten Richtungen einen Mindestquerschnitt (15) aufweist, wobei die besagte optische Einheit (11) zwischen der besagten Leuchteinheit (5) und der besagten lichtreflektierenden Vorrichtung (7) angeordnet ist;

   **dadurch gekennzeichnet, dass** die besagte optische Einheit (11) so konfiguriert ist, dass die besagte Brennfläche (12) kugelförmig ist,
   **und dadurch, dass** die besagte Leuchteinheit (5) und die besagte optische Einheit (11) so konfiguriert sind, dass das Verhältnis zwischen dem maximalen Durchmesser der Überschneidung zwischen dem besagten Lichtstrahl (6) und dem besagten Betriebsbereich (10) über den gesamten Betriebsbereich (10) hinweg, und dem Durchmesser ($w_F$) des besagten Mindestquerschnitts (15) nicht mehr als 1,15 beträgt.

2. Stereolithographiemaschine (1) nach Patentanspruch 1, **dadurch gekennzeichnet, dass** die besagte optische Einheit (11) feststehend ist.

3. Stereolithographiemaschine (1) nach einem jeden der Patentansprüche 1 oder 2, **dadurch gekennzeichnet, dass** die besagte Leuchteinheit (5) und die besagte optische Einheit (11) so konfiguriert sind, dass das besagte Verhältnis zwischen 1,10 und 1,15 liegt.

4. Stereolithographiemaschine (1) nach einem jeden der vorstehenden Patentansprüche, **dadurch gekennzeichnet, dass** die besagte Leuchteinheit (5) und die besagte optische Einheit (11) so konfiguriert sind, dass der besagte Durchmesser ($w_F$) des besagten Mindestquerschnitts (15) in einer gegebenen, vorbestimmten Konfiguration des besagten Betriebsbereichs (10) und mit einem gegebenen, vorbestimmten Abstand zwischen dem besagten Betriebsbereich (10) und der besagten lichtreflektierenden Vorrichtung (7) minimiert wird.

5. Stereolithographiemaschine (1) nach einem jeden der vorstehenden Patentansprüche, **dadurch gekennzeichnet, dass** die besagte Brennfläche (12) so angeordnet ist, dass sie den besagten Betriebsbereich (10) derart schneidet, dass ein erster Abschnitt (13) der besagten Brennfläche (12) innerhalb des besagten Grundmaterials (3) angeordnet ist, und dadurch, dass ein zweiter Abschnitt (14) der besagten Brennfläche (12) außerhalb des besagten Grundmaterials (3) angeordnet ist.

**6.** Stereolithographiemaschine (1) nach Patentanspruch 5, **dadurch gekennzeichnet, dass** die besagte Leuchteinheit (5) und die besagte optische Einheit (11) so konfiguriert sind, dass der maximale Überschneidungsbereich zwischen dem besagten Lichtstrahl (6) und dem besagten Betriebsbereich (10), wenn der besagte Lichtstrahl (6) zu dem besagten ersten Abschnitt (13) gerichtet ist, gleich dem maximalen Überschneidungsbereich zwischen dem besagten Lichtstrahl (6) und dem besagten Betriebsbereich (10) ist, wenn der besagte Lichtstrahl (6) zu dem besagten zweiten Abschnitt (14) gerichtet ist.

**7.** Stereolithographiemaschine (1) nach einem jeden der Patentansprüche 5 oder 6, **dadurch gekennzeichnet, dass** die besagte lichtreflektierende Vorrichtung (7) so konfiguriert ist, dass die Überschneidung zwischen der besagten Brennfläche (12) und dem besagten Betriebsbereich (10) ein Umfang (16) ist.

**8.** Stereolithographiemaschine (1) nach Patentanspruch 7, **dadurch gekennzeichnet, dass** die besagte Steuerlogikeinheit (19) so konfiguriert ist, dass der besagte Betriebsbereich (10) kreisförmig und mit dem besagten Umfang (16) konzentrisch ist.

**9.** Stereolithographiemaschine (1) nach Patentanspruch 8, **dadurch gekennzeichnet, dass** der besagte kreisförmige Betriebsbereich (10) in dem besagten Einfallsbereich (8) eingeschrieben ist.

**10.** Stereolithographiemaschine nach Patentanspruch 9, **dadurch gekennzeichnet, dass** der Durchmesser des besagten kreisförmige Betriebsbereichs (10) zwischen 170 mm und 190 mm liegt.

**11.** Stereolithographiemaschine (1) nach einem jeden der vorstehenden Patentansprüche, **dadurch gekennzeichnet, dass** die besagte optische Einheit (11) eine Linse oder ein Satz in Reihe angeordneter Linsen (17) ist.

**12.** Stereolithographiemaschine (1) nach einem jeden der vorstehenden Patentansprüche, **dadurch gekennzeichnet, dass** die besagte Leuchteinheit (5) so konfiguriert ist, dass sie einen kollimierten Lichtstrahl (6) abgibt.

**13.** Stereolithographiemaschine (1) nach Patentanspruch 12, **dadurch gekennzeichnet, dass** die besagte Leuchteinheit (5) einen Lasersender umfasst.

**14.** Stereolithographiemaschine (1) nach einem jeden der Patentansprüche 12 oder 13, **dadurch gekennzeichnet, dass** die besagte Leuchteinheit (5) so konfiguriert ist, dass der Querschnitt des besagten kollimierten Lichtstrahls (6) zwei wechselseitig orthogonalen Symmetrieachsen entsprechend symmetrisch ist.

**15.** Verfahren zur Konstruktion einer Stereolithographiemaschine (1) nach einem jeden der vorstehenden Patentansprüche, **dadurch gekennzeichnet, dass** es folgende Vorgänge umfasst:

- Definition einer Konfiguration für den besagten Betriebsbereich (10);
- Definition eines Abstands zwischen der besagten lichtreflektierenden Vorrichtung (7) und dem besagten Betriebsbereich (10);
- Berechnung der Werte einiger Konstruktionsparameter für die besagte Leuchteinheit (5) und die besagte optische Einheit (11) derart, dass der Wert des besagten Durchmessers ($w_F$) des besagten Mindestquerschnitts (15) minimiert wird, vorausgesetzt, der Wert des Verhältnisses zwischen dem maximalen Durchmesser der Überschneidung zwischen dem besagten Lichtstrahl (6) und dem besagten Betriebsbereich (10) über den gesamten Betriebsbereich (10) hinweg, und der Durchmesser ($w_F$) des besagten Mindestquerschnitts (15), ist kleiner oder gleich 1,15, wobei die besagten Konstruktionsparameter wenigstens den Durchmesser ($w_L$) und den Qualitätskoeffizienten ($M^2$) des besagten, auf die besagte optische Einheit (11) einfallenden Lichtstrahls (6) und die Brennlänge (f) der besagten optischen Einheit (11) umfassen;
- Wahl der besagten Leuchteinheit (5) und der besagten optischen Einheit (11) nach den besagten Werten der besagten Konstruktionsparameter.

**16.** Verfahren nach Patentanspruch 15, **dadurch gekennzeichnet, dass** die besagten Konstruktionsparameter einen Parameter umfassen, der für den Abbildungsfehler der besagten optischen Einheit (11) repräsentativ ist.

**Revendications**

**1.** Machine de stéréolithographie (1) comprenant:

- un récipient (2) contenant un matériel de base (3) à l'état liquide ou de pâte qui définit une surface extérieure (4) délimitant ledit matériel de base;
- un groupe émetteur de lumière (5) configuré de manière à émettre un faisceau lumineux (6);
- un dispositif réfléchissant la lumière (7) apte à dévier ledit faisceau lumineux (6) et à être contrôlé de manière à ce que ledit faisceau lumineux (6) soit incident sur un point quelconque d'une zone d'incidence (8) appartenant à ladite surface extérieure (4);
- une unité logique de contrôle (19) configurée pour contrôler ledit dispositif réfléchissant la lumière (7) de manière à ce que ledit faisceau lumineux (6) soit sélectivement incident sur un point quelconque d'une zone opérationnelle (10) appartenant à ladite zone d'incidence (8);
- une unité optique (11) configurée pour focaliser ledit faisceau lumineux (6) sur une surface focale (12) définie par les points où ledit faisceau lumineux (6) présente une section transversale minimale (15) le long des directions différentes définies par ledit dispositif réfléchissant la lumière (7), ladite unité optique (11) étant disposée entre ledit groupe émetteur de lumière (5) et ledit dispositif réfléchissant la lumière (7);

**caractérisée en ce que** ladite unité optique (11) est configurée de manière à ce que ladite surface focale (12) est sphérique,
**et en ce que** ledit groupe émetteur de lumière (5) et ladite unité optique (11) sont configurés de manière à ce que le rapport entre le diamètre maximum de l'intersection entre ledit faisceau lumineux (6) et ladite zone opérationnelle (10) sur l'entière zone opérationnelle (10), et le diamètre ($w_F$) de ladite section transversale minimale (15), soit inférieur à 1,15.

2. Machine de stéréolithographie (1) selon la revendication 1, **caractérisée en ce que** ladite unité optique (11) est fixe.

3. Machine de stéréolithographie (1) selon l'une quelconque des revendications 1 ou 2, **caractérisée en ce que** ledit groupe émetteur de lumière (5) et ladite unité optique (11) sont configurés de manière à ce que ledit rapport soit compris entre 1,10 et 1,15.

4. Machine de stéréolithographie (1) selon l'une quelconque des revendications précédentes, **caractérisée en ce que** ledit groupe émetteur de lumière (5) et ladite unité optique (11) sont configurés de manière à réduire ledit diamètre ($w_F$) de ladite section transversale minimale (15), avec une configuration prédéfinie donnée de ladite zone opérationnelle (10) et une distance prédéfinie donnée entre ladite zone opérationnelle (10) et ledit dispositif réfléchissant la lumière (7).

5. Machine de stéréolithographie (1) selon l'une quelconque des revendications précédentes, **caractérisée en ce que** ladite surface focale (12) est disposée de manière à croiser ladite zone opérationnelle (10) de manière à ce qu'une première portion (13) de ladite surface focale (12) soit disposée à l'intérieur dudit matériel de base (3) et **en ce qu'**une deuxième portion (14) de ladite surface focale (12) soit disposée à l'extérieur dudit matériel de base (3).

6. Machine de stéréolithographie (1) selon la revendication 5, **caractérisée en ce que** ledit groupe émetteur de lumière (5) et ladite unité optique (11) sont configurés de manière à ce que la zone d'intersection maximale entre ledit faisceau lumineux (6) et ladite zone opérationnelle (10), quand ledit faisceau lumineux (6) est tourné vers ladite première portion (13), est égale à la zone d'intersection maximale entre ledit faisceau lumineux (6) et ladite zone opérationnelle (10) quand ledit faisceau lumineux (6) est tourné vers ladite deuxième portion (14).

7. Machine de stéréolithographie (1) selon l'une quelconque des revendications 5 ou 6, **caractérisée en ce que** ledit dispositif réfléchissant la lumière (7) est configuré de manière à ce que l'intersection entre ladite surface focale (12) et ladite zone opérationnelle (10) est une circonférence (16).

8. Machine de stéréolithographie (1) selon la revendication 7, **caractérisée en ce que** ladite unité logique de contrôle (19) est configurée de manière à ce que ladite zone opérationnelle (10) est circulaire et concentrique avec ladite circonférence (16).

9. Machine de stéréolithographie (1) selon la revendication 8, **caractérisée en ce que** ladite zone opérationnelle circulaire (10) est inscrite dans ladite zone d'incidence (8).

10. Machine de stéréolithographie selon la revendication 9, **caractérisée en ce que** ladite zone opérationnelle circulaire (10) présente un diamètre compris entre 170 mm et 190 mm.

**11.** Machine de stéréolithographie (1) selon l'une quelconque des revendications précédentes, **caractérisée en ce que** ladite unité optique (11) est une lentille ou un jeu de lentilles (17) disposées en série.

**12.** Machine de stéréolithographie (1) selon l'une quelconque des revendications précédentes, **caractérisée en ce que** ledit groupe émetteur de lumière (5) est configuré de manière à émettre un faisceau lumineux collimaté (6).

**13.** Machine de stéréolithographie (1) selon la revendication 12, **caractérisée en ce que** ledit groupe émetteur de lumière (5) comprend un émetteur laser.

**14.** Machine de stéréolithographie (1) selon l'une quelconque des revendications 12 ou 13, **caractérisée en ce que** ledit groupe émetteur de lumière (5) est configuré de manière à ce que la section transversale dudit faisceau lumineux collimaté (6) est symétrique selon deux axes de symétrie réciproquement perpendiculaires.

**15.** Méthode pour la réalisation d'une machine de stéréolithographie (1) selon l'une quelconque des revendications précédentes, **caractérisée en ce qu'**elle comprend les opérations suivantes:

- définir une configuration pour ladite zone opérationnelle (10);
- définir une distance entre ledit dispositif réfléchissant la lumière (7) et ladite zone opérationnelle (10);
- calculer les valeurs de certains paramètres de projet dudit groupe émetteur de lumière (5) et ladite unité optique (11) de manière à réduire la valeur dudit diamètre ($w_F$) de ladite section transversale minimale (15) à condition que la valeur du rapport entre le diamètre maximum de l'intersection entre ledit faisceau lumineux (6) et ladite zone opérationnelle (10) sur l'entière zone opérationnelle (10), et le diamètre ($w_F$) de ladite section transversale minimale (15), est inférieure ou égale à 1,15, lesdits paramètres de projet comprenant au moins le diamètre ($w_L$) et le coefficient de qualité ($M^2$) dudit faisceau lumineux (6) incident sur ladite unité optique (11), et la longueur focale (f) de ladite unité optique (11);
- sélectionner ledit groupe émetteur de lumière (5) et ladite unité optique (11) selon lesdites valeurs desdits paramètres de projet.

**16.** Méthode selon la revendication 15, **caractérisée en ce que** lesdits paramètres de projet comprennent un paramètre qui représente l'aberration de ladite unité optique (11).

Fig. 1

Fig. 2

Fig. 3

Fig. 4

Fig. 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5151813 A